# EUROPEAN PATENT APPLICATION

(11) **EP 4 844 808 A1**
(43) Date of publication of application: **25.11.2026**
(21) Application number: 25742032.3
(22) Date of filing: 17.01.2025
(51) Int. Cl.: H01L 21/683, H02N 13/00

(54) **ELECTROSTATIC CHUCK**

(30) Priority: 18.01.2024 JP 2024006083
(71) Applicant: Tomoegawa Corporation, Tokyo 104-8335 (JP)
(72) Inventor: ADACHI Ayana, Shizuoka-shi, Shizuoka 424-0831 (JP); MORIUCHI Hideki, Shizuoka-shi, Shizuoka 421-0192 (JP)
(74) Representative: V.O.
(86) International application number: PCT/JP2025/001416
(87) International publication number: WO 2025/154807

(57) **Abstract**

An electrostatic chuck (1) comprising a dielectric layer (10) and a first resin layer (20) provided on the dielectric layer (10), wherein the first resin layer (20) has a holding surface for holding a member to be held, and the first resin layer (20) has an elastic modulus of 10 MPa or more and 1000 MPa or less at 40°C in a region in contact with the dielectric layer (10).

## Description

### TECHNICAL FIELD

The present invention relates to an electrostatic chuck.

Priority is claimed on Japanese Patent Application No. 2024-006083, filed January 18, 2024, the content of which is incorporated herein by reference.

### BACKGROUND ART

When manufacturing semiconductor integrated circuits using semiconductor wafers, or when manufacturing liquid crystal panels using insulating substrates such as glass substrates or films, it is necessary to adsorb and hold the substrate, such as the semiconductor wafer, glass substrate, or insulating substrate, to a predetermined location. An electrostatic chuck is used to hold the component to be held. In recent years, as the size of components held by electrostatic chucks, such as semiconductor wafers and glass substrates, has increased, there are challenges in increasing the suction force of the electrostatic chucks and reducing particles on the back surface of the components to be held.

To solve the above problems, an electrostatic chuck device is known in which, for example, a holding member made of resin material is provided protruding from a base to hold a plate-shaped workpiece by suction, and an electrostatic chuck having an adsorption electrode inside is disposed in at least a part of the space formed between the plate-shaped workpiece and the base via the holding member so as to be lower than the holding member, so that the electrostatic chuck electrostatically attracts the plate-shaped workpiece in a non-contact state (see, for example, Patent Document 1). In this electrostatic chuck device, the elastic modulus of the resin material constituting the holding member is between 0.5 MPa and 10 MPa.

Furthermore, an electrostatic adsorption member is known, which comprises a contact member formed of a dielectric material and having a contact surface on a first side facing the surface of an object that can be deformed to conform to the surface of the object, and an electrode portion provided on a second side of the contact member opposite to the first side, to which a voltage can be applied to the contact member, wherein the electrode portion comprises multiple layers of electrodes laminated with an insulating layer in between (see, for example, Patent Document 2). In this electrostatic adsorption member, the contact member is made of a dielectric material that is elastic and flexible, allowing it to deform to conform to the surface of the object.

### CITATION LIST

### PATENT DOCUMENT

Patent Document 1: International Publication No. 2012/026421
Patent Document 2: Japanese Unexamined Patent Publication No. 2023-37788

### SUMMARY OF INVENTION

### TECHNICAL PROBLEM

However, the inventions described in Patent Documents 1 and 2 lacked sufficient durability (corrosion resistance) of the holding member (contact member) against corrosive gases and sufficient resistance to contamination (contamination resistance).

The present invention has been made in view of the above circumstances, and aims to provide an electrostatic chuck in which the holding member that holds the member to be held is excellent in durability (thermal durability, corrosion resistance, etc.) and stain resistance (low volatility, particle resistance, etc.).

### SOLUTION TO PROBLEM

In order to achieve the aforementioned objects, the present invention has the following aspects.
[1] An electrostatic chuck comprising: a dielectric layer; and a first resin layer provided on the dielectric layer, wherein the first resin layer has a holding surface for holding a member to be held, and the first resin layer has an elastic modulus of 10 MPa or more and 1000 MPa or less at 40°C in a region in contact with the dielectric layer.
[2] The electrostatic chuck according to [1], wherein the first resin layer has a mass loss rate of 0.5% or less when heated at 150°C for 24 hours.
[3] The electrostatic chuck according to [1] or [2], wherein the first resin layer has a tensile fracture elongation of 30% or more and 400% or less.
[4] The electrostatic chuck according to any one of [1] to [3], wherein the first resin layer has an elastic modulus of 100 MPa or more and 12,000 MPa or less at 40°C in the region in contact with the member to be held.
[5] The electrostatic chuck according to any one of [1] to [4], wherein, under a condition of 140°C, the peel strength of the first resin layer with respect to the dielectric layer is 0.1 N/25 mm or more and 2.0 N/25 mm or less.
[6] The electrostatic chuck according to any one of [1] to [5], wherein the first resin layer comprises a plurality of unit resin layers arranged spaced apart from each other.
[7] The electrostatic chuck according to any one of [1] to [6], wherein, in a plan view of the dielectric layer, the area of the holding surface is 50% or less of the area of the dielectric layer.
[8] The electrostatic chuck according to any one of [1] to [7], further comprising a second resin layer between the dielectric layer and the first resin layer.
[9] The electrostatic chuck according to [8], wherein the second resin layer covers a surface of the dielectric layer facing the first resin layer and the side surface of the dielectric layer.

### EFFECTS OF INVENTION

According to the present invention, it is possible to provide an electrostatic chuck that is excellent in durability (thermal durability, corrosion resistance, etc.) and contamination resistance (low volatility, particle resistance, etc.).

### BRIEF DESCRIPTION OF DRAWINGS

[FIG. 1] A schematic cross-sectional view of an electrostatic chuck according to one embodiment of the present invention, taken along the thickness direction of the electrostatic chuck.
[FIG. 2] A schematic cross-sectional view of an electrostatic chuck according to one embodiment of the present invention, taken along the thickness direction of the electrostatic chuck.
[FIG. 3] A schematic cross-sectional view of an electrostatic chuck according to one embodiment of the present invention, taken along the thickness direction of the electrostatic chuck.

### EMBODIMENTS FOR CARRYING OUT INVENTION

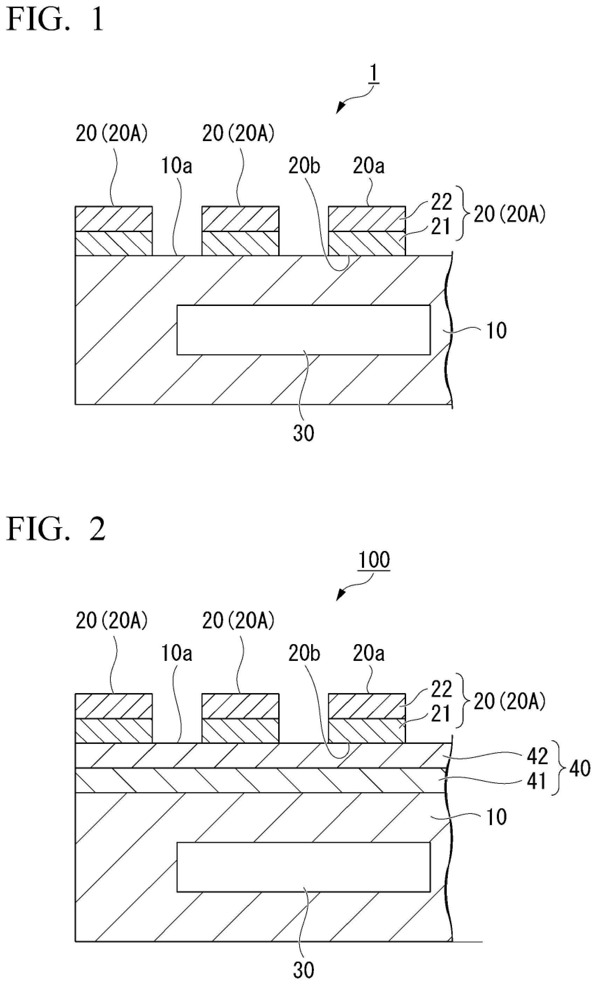

The following describes an electrostatic chuck according to one embodiment of the present invention, based on the drawings. FIG. 1 schematically shows an electrostatic chuck according to one embodiment of the present invention, and is a cross-sectional view along the thickness direction of the electrostatic chuck.

Please note that, for the sake of clarity, the drawings used in the following explanation may show enlarged versions of key features, and the dimensional ratios of each component may differ from those of the actual components. Furthermore, the materials, dimensions, etc., exemplified in the following description are merely examples, and the present invention is not limited thereto; it may be implemented with appropriate modifications without a scope that does not depart from the gist of the present invention.

### [Electrostatic Chuck]

As shown in FIG. 1, an electrostatic chuck 1 of the present embodiment comprises a dielectric layer 10 and a first resin layer 20 provided on the dielectric layer 10. In other words, the first resin layer 20 is provided on one main surface (upper surface) 10a of the dielectric layer 10. The electrostatic chuck 1 has the first resin layer 20 as a holding member for holding the member to be held, and can be used as an adsorption device for adsorbing and holding the member to be held.

The first resin layer 20 has a first adhesive layer 21 and a first base material layer 22 which are laminated sequentially from the one main surface 10a side of the dielectric layer 10.

The electrostatic chuck 1 may, for example, have internal electrodes 30 inside the dielectric layer 10, as shown in FIG. 1.

The electrostatic chuck 1, in a plan view, has, for example, a circular shape. In a cross-sectional view, as shown in FIG. 1, it is preferable that the first resin layer 20 includes a plurality of unit resin layers 20A arranged spaced apart from each other. In the electrostatic chuck 1, for example, a plurality of unit resin layers 20A are arranged concentrically on the one main surface 10a of the dielectric layer 10.

The dielectric layer 10 can be formed from, for example, heat-resistant resins such as polyimide, polyamide-imide, aromatic polyetherketone, and polyphenylene sulfide, or ceramics such as alumina, silicon carbide (SiC), and yttrium oxide. The dielectric layer 10 is positioned on the side opposite to the side where the member to be held is attracted.

The first resin layer 20 has a holding surface for holding the member to be held. The holding surface of the first resin layer 20 is one main surface (upper surface) 20a of the first resin layer 20.

The first resin layer 20 has an elastic modulus at 40°C of 10 MPa to 1000 MPa in the region in contact with the dielectric layer 10, preferably 50 MPa to 900 MPa, and more preferably 50 MPa to 800 MPa. When the modulus of elasticity is above the lower limit, the strength and crosslinking density increase, and corrosion resistance to corrosive gases improves. As a result, the durability of the electrostatic chuck 1 is improved. When the elastic modulus is below the upper limit, flexibility is improved, and the generation of particles due to chipping or peeling during deformation can be suppressed. As a result, the contamination resistance of the electrostatic chuck 1 is improved. Specifically, the region of the first resin layer 20 that is in contact with the dielectric layer 10 refers to the other main surface (bottom surface) 20b of the first resin layer 20 and the region near it. The region near the other main surface 20b of the first resin layer 20 is a region of 5 µm or less in the thickness direction from the other main surface 20b of the first resin layer 20.

A dynamic viscoelastic device can be used to measure the elastic modulus at 40°C in the region of the first resin layer 20 that is in contact with the dielectric layer 10. For example, a region of the first resin layer 20 that is in contact with the dielectric layer 10 can be cut out, and a value can be obtained by measuring it under conditions of a heating rate of 5°C/min and a measurement frequency of 10 Hz.

Furthermore, the elastic modulus at 40°C in the region of the first resin layer 20 that is in contact with the dielectric layer 10 can be controlled by the strength and crosslinking density of the resin used in the first resin layer 20, as well as by the addition of inorganic materials.

The first resin layer 20 has an elastic modulus at 40°C of 100 MPa to 12,000 MPa in the region in contact with the member to be held, and preferably 500 MPa to 10,000 MPa. When the modulus of elasticity is above the lower limit, the strength and crosslinking density increase, and corrosion resistance to corrosive gases improves. As a result, the durability of the electrostatic chuck 1 is improved. When the elastic modulus is below the upper limit, flexibility is improved, and the generation of particles due to chipping or peeling during deformation can be suppressed. As a result, the contamination resistance of the electrostatic chuck 1 is improved. Specifically, the region of the first resin layer 20 that is in contact with the member to be held refers to the one main surface 20a of the first resin layer 20 and the region in the vicinity thereof. The region in the vicinity of the one main surface 20a of the first resin layer 20 is the region of the first resin layer 20 that extends 10 µm or less in the thickness direction from the one main surface 20a.

The elastic modulus at 40°C in the region of the first resin layer 20 that is in contact with the member to be held can be measured in the same manner as the elastic modulus at 40°C in the region of the first resin layer 20 that is in contact with the dielectric layer 10.

Furthermore, the elastic modulus at 40°C in the region of the first resin layer 20 that is in contact with the member to be held can be controlled by the strength and crosslinking density of the resin used in the first resin layer 20, as well as by the addition of inorganic materials.

The first resin layer 20 preferably has a mass loss rate of 0.5% or less when heated at 150°C for 24 hours, more preferably 0.4% or less, and even more preferably 0.3% or less. If the mass loss rate is below the upper limit, contamination of the held member by volatile substances can be suppressed during the plasma treatment process, thereby improving contamination resistance.

A thermogravimetric differential thermal analyzer (TG-DTA) can be used to measure the mass loss rate of the first resin layer 20 when heated at 150°C for 24 hours. For example, under a nitrogen atmosphere, the temperature can be raised to 150°C at a heating rate of 5°C/min, and then maintained at 150°C for 24 hours for measurement.

The mass loss rate of the first resin layer 20 can be controlled by the crosslinking density, impurity content, low molecular weight content, and addition of inorganic materials in the resin constituting the first resin layer 20.

The first resin layer 20 preferably has a tensile fracture elongation of 30% to 400%, more preferably 50% to 300%, and even more preferably 50% to 200%. When the tensile fracture elongation is equal to or greater than the lower limit, flexibility is improved, and the generation of particles due to chipping or peeling during deformation can be suppressed. As a result, the contamination resistance of the electrostatic chuck 1 is improved. When the tensile fracture elongation is equal to or less than the upper limit, the strength increases and corrosion resistance to corrosive gases improves. As a result, the durability of the electrostatic chuck 1 is improved.

A universal material testing machine can be used to measure the tensile fracture elongation of the first resin layer 20. For example, both ends of the first resin layer 20 cut into strips (1 mm wide x 4 mm long) are gripped together by the gripping section of a universal material testing machine with the upper and lower distance set to 2 mm. The machine is then pulled at a tensile speed of 10 mm/min, and the distance the gripping section moves before the first resin layer 20 breaks is measured to obtain a value.

Furthermore, the tensile fracture elongation of the first resin layer 20 can be controlled by the molecular weight and crosslinking density of the resin used in the first resin layer 20, as well as by the addition of inorganic materials.

In a plan view of the dielectric layer 10, the area of the holding surface of the first resin layer 20 (the one main surface 20a of the first resin layer 20) is preferably 50% or less, more preferably 30% or less, and even more preferably 20% or less, relative to the area of the dielectric layer 10 (the area of the one main surface (upper surface) 10a of the dielectric layer 10). When the area ratio of the holding surface of the first resin layer 20 to the area of the dielectric layer 10 is within the above range, the area in contact between the holding surface of the first resin layer 20 and the member to be held decreases, thus reducing the number of particles adhering to the surface of the member to be held that is in contact with the holding surface of the first resin layer 20. As a result, the contamination resistance of the electrostatic chuck 1 is improved.

The first resin layer 20 may be composed of the unit resin layers 20A. Furthermore, in the first resin layer 20, the composition of all unit resin layers 20A may be the same or different. The configuration referred to here is the configuration of the first adhesive layer 21 and the configuration of the first base material layer 22, which will be described later. If all unit resin layers 20A have the same structure, uniform plasma treatment can be performed on the upper surface of the member to be held, making it suitable for use in an electrostatic chuck device. When the composition of the unit resin layers 20A differs, the plasma treatment on the upper surface of the member to be held can be intentionally made non-uniform, making it suitable for use in an electrostatic chuck device.

The first adhesive layer 21 can be an adhesive such as a thermoplastic polyimide adhesive, a thermosetting polyimide adhesive, a polyamide adhesive, an epoxy adhesive, a polyester adhesive, a silicone adhesive, an olefin adhesive, or an anchor coating agent. From the viewpoint of corrosion resistance and stain resistance, thermoplastic polyimide adhesives, thermosetting polyimide adhesives, polyamide adhesives, and epoxy adhesives can be preferably used.

The thickness of the first adhesive layer 21 is not particularly limited, but is preferably 1 µm or more and 25 µm or less, more preferably 3 µm or more and 15 µm or less, and even more preferably 3 µm or more and 10 µm or less. If the thickness of the first adhesive layer 21 is greater than or equal to the lower limit, the adhesive strength to the dielectric layer 10 increases, and thermal stress during the plasma treatment process can be reduced, thereby improving durability. When the thickness of the first adhesive layer 21 is less than or equal to the upper limit, the adhesive strength to the dielectric layer 10 increases, and the area of the first adhesive layer 21 in contact with the corrosive gas decreases, thereby improving corrosion resistance. As a result, the durability of the electrostatic chuck 1 is improved.

Examples of resins constituting the first base material layer 22 include polyimide, polyphenylene sulfide, aromatic polyetherketone, polyimide resin, polyethylene terephthalate, polypropylene, and polytetrafluoroethylene.

The thickness of the first base material layer 22 is not particularly limited, but is preferably 5 µm or more and 100 µm or less, more preferably 5 µm or more and 40 µm or less, and even more preferably 10 µm or more and 30 µm or less. When the thickness of the first base material layer 22 is greater than or equal to the lower limit, the corrosion resistance of the first resin layer 20 to corrosive gases in the holding surface direction increases. As a result, the durability of the electrostatic chuck 1 is improved. When the thickness of the first base material layer 22 is less than or equal to the upper limit, the holding force on the member to be held increases, and the risk of contaminants getting between the holding surface of the first resin layer 20 and the member to be held decreases. As a result, the contamination resistance of the electrostatic chuck 1 is improved.

The electrostatic chuck 1 of the present embodiment is highly durable and can be used repeatedly in semiconductor manufacturing processes. However, if the holding surface deteriorates or becomes contaminated by corrosive gases or particles, the electrostatic chuck 1 can be used for an even longer period by replacing the first resin layer 20 (holding surface) (repairability). In other words, the first resin layer 20 may be easily peeled off from the dielectric layer 10 as long as the function of the electrostatic chuck 1 is not impaired, and it is preferable that no residue of the first resin layer 20 remains on the surface of the dielectric layer 10 from the viewpoint of repairability. Specifically, the first resin layer 20 preferably has a peel strength of 0.1 N/25 mm or more and 3.0 N/25 mm or less from the first adhesive layer 21 to the dielectric layer 10 at 25°C, and more preferably 0.2 N/25 mm or more and 2.0 N/25 mm or less. When measuring this peel strength, it is more preferable that the dielectric layer 10 and the adhesive layer 21 are separated from each other without leaving any residue. This makes it easy to remove the first resin layer 20 from the electrostatic chuck 1. Therefore, by replacing the first resin layer 20 (the first base material layer 22 and the first adhesive layer 21) that has deteriorated due to corrosive gas, the electrostatic chuck 1 can be easily maintained in good condition, and as a result, the durability of the electrostatic chuck 1 can be maintained.

Furthermore, the peel strength of the first resin layer 20 against the dielectric layer 10 at 140°C is preferably 0.1 N/25 mm or more and 2.0 N/25 mm or less, and more preferably 0.1 N/25 mm or more and 1.0 N/25 mm or less. When measuring this peel strength, it is more preferable that the dielectric layer 10 and the adhesive layer 21 are separated from each other without leaving any residue. This makes it easy to remove the first resin layer 20 from the electrostatic chuck 1. Therefore, by replacing the first resin layer 20 (the first base material layer 22 and the first adhesive layer 21) that has deteriorated due to corrosive gas, the electrostatic chuck 1 can be easily maintained **in** good condition, and as a result, the durability of the electrostatic chuck 1 is improved.

The method for measuring the peel strength of the first adhesive layer 21 to the dielectric layer 10 at 25°C and 140°C is not particularly limited, but it can be measured in accordance with JIS-Z-0237. Specifically, the first resin layer 20 is cut into strips 25 mm wide from the holding surface side of the electrostatic chuck 1. Then, the electrostatic chuck 1 is placed on a universal tensile testing machine (A&D Co., Ltd. RTH-2410), and the longitudinal end of the strip-shaped first resin layer 20 is gripped by a test measurement jig provided on the universal tensile testing machine. Subsequently, the strip-shaped first resin layer 20 is peeled from the dielectric layer 10 under the conditions of test temperatures of 25°C and 140°C, peel angle of 90°, and test speed of 200 mm/min to obtain the peel strength. This test is repeated three times, and the average peel strength can be used as the peel strength.

Furthermore, the peel strength of the first adhesive layer 21 from the dielectric layer 10 decreases steadily from 25°C to 140°C. The cause is thought to be a decrease in the cohesive force of the first adhesive layer 21. When the electrostatic chuck 1 is used in a semiconductor manufacturing apparatus, the ambient temperature inside the apparatus and the temperature of the holding surface (the one main surface 20a of the first resin layer 20) are adjusted in accordance with the semiconductor manufacturing process. When the operating temperature range of the electrostatic chuck 1 is 140°C or lower, the adhesive peel strength of the first adhesive layer 21 to the dielectric layer 10 at 140°C represents the durability of the first adhesive layer 21 at 140°C. If this peel strength is 0.1 N/25 mm or higher, damage to the first resin layer 20 during the semiconductor manufacturing process can be prevented. Furthermore, during repair, the first adhesive layer 21 can be peeled off from the dielectric layer 10 at room temperature (25°C), which suppresses damage to the electrostatic chuck 1 and maintains the quality of the electrostatic chuck 1 after repair, which is preferable. For example, if the peel strength of the first adhesive layer 21 against the dielectric layer 10 at 25°C is 3.0 N/25 mm or less, the possibility of residue being generated between them decreases, the quality of the electrostatic chuck 1 after repair is maintained, and even if residue is generated between them, the possibility of damage to the electrostatic chuck 1 can be reduced. If it is difficult to peel the first adhesive layer 21 from the dielectric layer 10 at room temperature (25°C), the peel strength of the first adhesive layer 21 may be reduced at a high temperature (140°C) and repair may be performed. Therefore, the peel strength of the first adhesive layer 21 against the dielectric layer 10 is evaluated at 25°C and 140°C.

The internal electrode 30 is not particularly limited and may be composed of, for example, a layered conductor. The conductor of the internal electrode 30 is not particularly limited, but one or more metals such as copper, aluminum, gold, silver, platinum, chromium, nickel, tungsten, and stainless steel are preferably used. The conductor of the internal electrode 30 may be an alloy containing at least one of these metals, or a mixture with a ceramic material. Examples of ceramic materials include alumina, silicon carbide, and yttrium oxide.

The electrostatic chuck 1 of the present embodiment has a first resin layer 20 that holds the member to be held, which is excellent in durability and stain resistance.

### [Other embodiments]

However, the present invention is not limited to the embodiment described above.

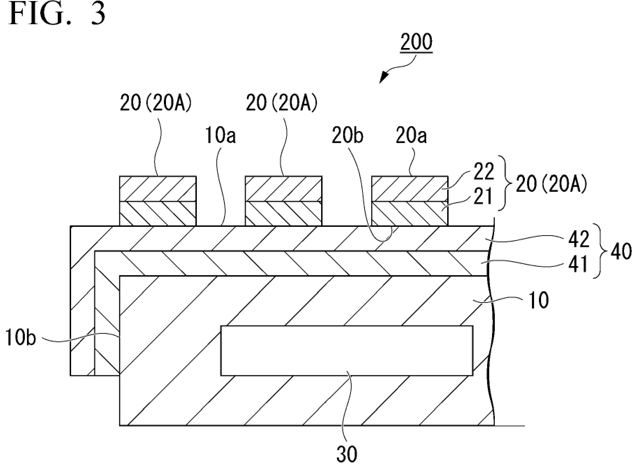

For example, modifications such as those shown in FIGS. 2 and 3 may be adopted. In the modified examples, the same reference numerals are used for parts identical to those in the above embodiment, with their descriptions being omitted and only the differences being described.

### [First Modification]

In the electrostatic chuck 100 of the first modified example shown in FIG. 2, a second resin layer 40 is provided between the dielectric layer 10 and the first resin layer 20.

The second resin layer 40 has a second adhesive layer 41 and a second base material layer 42 which are laminated sequentially from the one main surface 10a side of the dielectric layer 10.

The second adhesive layer 41 has the same configuration as the first adhesive layer 21.

The second base material layer 42 has the same configuration as the first base material layer 22.

According to the modified electrostatic chuck 100 of the first modification, the second resin layer 40 is provided between the dielectric layer 10 and the first resin layer 20, thereby further improving the corrosion resistance and particle resistance of the first resin layer 20.

### [Second Modification]

In the electrostatic chuck 200 of the second modified example shown in FIG. 3, the second resin layer 40 covers the surface of the dielectric layer 10 facing the first resin layer (the one main surface 10a of the dielectric layer 10) and a side surface 10b of the dielectric layer 10.

In the electrostatic chuck 100 of the first modified example, the second resin layer 40 covers the surface of the dielectric layer 10 facing the first resin layer and the side surface 10b of the dielectric layer 10, thereby improving the corrosion resistance and particle resistance of the dielectric layer 10.

### EXAMPLES

The present invention will be described in more detail below with reference to examples and comparative examples, but the present invention is not limited to the following examples.

### [Fabrication of electrostatic chuck]

An example of a method for manufacturing the electrostatic chuck of this embodiment will be described. However, the present invention is not limited to the manufacturing method described herein.

A thin metal film is formed by depositing a metal such as copper onto the surface of the base (the upper surface in the thickness direction). Subsequently, etching is performed to pattern the thin metal film into a predetermined shape, thereby forming the electrode. There can be one electrode or multiple electrodes. **In** addition to holding electrodes for holding the member to be held, the electrodes may also include high-frequency electrodes for controlling high-frequency plasma, or thermal resistance elements for heating the member to be held.

Next, an adhesive layer is bonded to the upper surface of the electrode so as to cover the end of the electrode, and a dielectric layer is bonded via the adhesive layer to form a laminate. The dielectric layer may be formed by thermal spraying, by applying and solidifying a resin or inorganic paste, or by a combination of multiple layers.

Next, an adhesive layer was bonded to the laminate, and a resin film was bonded via the adhesive layer to form a second resin layer. Alternatively, a resin may be applied to the top surface or both the top and sides of the laminate to form a second resin layer. The resin is not particularly limited, but it can be formed by applying the resin and then drying or heating it to solidify it.

Next, an adhesive sheet, in which the first base material layer was bonded to the first adhesive layer, was bonded onto the second resin layer. In this case, die-cut adhesive sheets may be used. The first resin layer is not particularly limited, but may be formed by applying the resin and then drying or heating it to solidify it.

### [Example 1]

The electrostatic chuck of Example 1 was fabricated to have the configuration shown in Table 1. Specifically, a thin copper film was formed by depositing copper onto the surface of a base (300 mm in diameter, 5 mm thick). The thickness of the copper thin film was 10 µm. Subsequently, etching was performed to pattern the thin copper film into a predetermined shape, thereby forming electrodes. Subsequently, an adhesive sheet 1 was bonded to the upper surface of the electrode so as to cover the end of the electrode, and the base material 4 was bonded via the adhesive sheet 1 to form a laminate. Subsequently, the adhesive sheet 1 was bonded to the top surface and side surface of the laminate, and the base material 1 was punched out and bonded via the adhesive sheet 1 to form a second resin layer. Next, the adhesive tape, which had the adhesive sheet 1 bonded to the base material 1, was bonded onto the second resin layer. Here, the adhesive tape used was die-cut so that 150 discs, each with a diameter of 4 mm, were uniformly arranged on the second resin layer. After bonding the adhesive sheet, base material 1, base material 4, laminate, and second resin layer, the material was heated at 180°C for 1 hour to cure and bond it.

### [Example 2]

The electrostatic chuck for Example 2 was fabricated in the same manner as in Example 1, with the configuration shown in Table 1. In the electrostatic chuck of Example 2, the second resin layer was formed only on the upper surface of the laminate.

### [Example 3]

The electrostatic chuck of Example 3 was fabricated in the same manner as in Example 1, with the configuration shown in Table 1. In the electrostatic chuck of Example 3, the second resin layer was not formed, and the first resin layer was formed on the upper surface of the dielectric layer.

### [Example 12]

The electrostatic chuck of Example 12 was fabricated in the same manner as in Example 1, with the configuration shown in Table 1. In the electrostatic chuck of Example 12, the first base material layer is not formed. As a result, the upper surface of the first adhesive layer was used as the holding surface.

### [Examples 4-11, 13-27, Comparative Example 1]

Electrostatic chucks for each embodiment were fabricated in the same manner as in Example 1, as shown in Tables 1 to 5.

### [Comparative Example 2]

The electrostatic chuck of Comparative Example 2 was fabricated to have the configuration shown in Table 4. Specifically, a thin copper film was formed by depositing copper onto the surface of a base (300 mm in diameter, 5 mm thick). The thickness of the copper thin film was 10 µm. Subsequently, etching was performed to pattern the thin copper film into a predetermined shape, thereby forming electrodes. Subsequently, an adhesive sheet 1 was bonded to the upper surface of the electrode so as to cover the end of the electrode, and an alumina plate (300 mm in diameter, 0.125 mm thick) was bonded to it via the adhesive sheet 1 to create an electrostatic chuck. After bonding the adhesive sheet, electrode, base, and alumina plate, the material was heated at 180°C for 1 hour to cure and bond it.

### [Evaluation]

### "Area ratio of holding surface of first resin layer"

In a plan view of the dielectric layer, the area of the holding surface of the first resin layer was measured in relation to the area of the dielectric layer (the area of one of the one main surface of the dielectric layer). Specifically, it was calculated as the average value of the values obtained using the following formula with publicly available image analysis software. The results are shown in Tables 1 to 4. 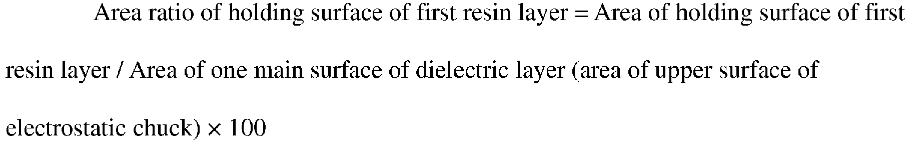 Area ratio of holding surface of first resin layer = Area of holding surface of first resin layer / Area of one main surface of dielectric layer (area of upper surface of electrostatic chuck) × 100

### "Tensile fracture elongation of first resin layer"

The tensile fracture elongation of the first resin layer was measured. Specifically, both long ends of a first resin layer, cut into strips (1 mm wide x 4 mm long), were gripped together by the gripping parts of a universal material testing machine (RTF-1310, manufactured by A&D Co., Ltd.) with the upper and lower distance set to 2 mm. The material was then pulled at a tensile speed of 10 mm/min, and the distance the gripping parts moved before the first resin layer fractured was measured to obtain the measurement value. The results are shown in Tables 1 to 4.

### "Mass loss rate when first resin layer is heated at 150°C for 24 hours"

The mass loss rate was measured when the first resin layer was heated at 150°C for 24 hours. Specifically, measurements were performed using a thermogravimetric differential thermal analyzer (TG-DTA) (Shimadzu Corporation, TG/DTA simultaneous measurement device DTG-60) under the following conditions. Under a nitrogen atmosphere, the temperature was raised to 150°C at a heating rate of 5°C/min, and then maintained at 150°C for 24 hours. The mass loss rate was calculated from the obtained values to obtain the measured value. The results are shown in Tables 1 to 4.

### "Elastic modulus at 40°C in region of first resin layer in contact with dielectric layer"

The elastic modulus at 40°C was measured in the region of the first resin layer that is in contact with the dielectric layer. Specifically, measurements were performed using a dynamic viscoelasticity analyzer (TA Instruments HR-20) under the following conditions. Multiple sections of the first resin layer that are in contact with the dielectric layer were cut out along the first resin layer to a thickness of 5 µm, and these were laminated to a thickness of 200 µm ± 20 µm. After standing at 40°C for 30 minutes, measurements were taken at a measurement frequency of 10 Hz, and the elastic modulus at 40°C was calculated. The results are shown in Tables 1 to 4.

### "Elastic modulus at 40°C in region of first resin layer in contact with member to be held"

Similar to the elastic modulus at 40°C of the region of the first resin layer in contact with the dielectric layer, the elastic modulus at 40°C of the region of the first resin layer in contact with the member to be held was measured. The results are shown in Tables 1 to 4.

### "Corrosion resistance"

The corrosion resistance of the first resin layer was evaluated. Specifically, the first resin layer was cut into a disc shape with a diameter of 4 mm. Subsequently, the samples were exposed to hydrogen fluoride gas for 24 hours under the following conditions, and the weight change rate before and after the test was calculated to obtain the values. Corrosion resistance was evaluated as follows: "A" if the weight change before and after the test was less than 0.01%, "B" if the weight change before and after the test was 0.01% or more but less than 0.05%, "C" if it was 0.05% or more but less than 0.15%, and "D" if it was 0.15% or more. The results are shown in Tables 1 to 4.

### "Holding force"

The holding force of the holding surface was evaluated. Specifically, the upper surface of the holding member was maintained at 50°C, a silicon dummy wafer was used as the member to be held, the dummy wafer was adsorbed onto the holding surface under vacuum (10 Pa or less), a voltage of +2.5 kV was applied to the electrode, and then it was held for 30 seconds. Subsequently, while the voltage was still applied, helium gas was flowed into the space surrounded by the dielectric layer, the first resin layer, and the dummy wafer. The amount of helium gas leakage at a gas pressure of 100 Torr was measured, and the holding force was evaluated.

The retention capacity was evaluated as follows: "A" if the helium gas leak was less than 0.5 sccm, "B" if it was 0.5 sccm or more but less than 1.0 sccm, "C" if it was 1.0 sccm or more but less than 3.0 sccm, and "D" if it was 3.0 sccm or more. The results are shown in Tables 1 to 4.

### "Particle resistance"

Particle resistance was evaluated. Specifically, similar to the evaluation of "holding force", a dummy wafer was adsorbed, and then the holding surface was heated from 50°C to 150°C at a heating rate of 5°C/min. Once it reached 150°C, the holding surface was cooled down to 50°C at a cooling rate of 5°C/min. Subsequently, the voltage application was stopped, the dummy wafer was removed from the holding surface, and the number and size of particles attached to the side of the dummy wafer that had been adsorbed to the holding surface were measured using a wafer surface inspection device (Topcon Co., Ltd., product name WM-7S). The number of particles with a diameter of 0.5 µm or more and less than 1.0 µm, and the number of particles with a diameter of 1.0 µm or more were measured. Particle resistance was evaluated as follows: "A" if the total number of particles was less than 1000, "B" if the number of particles was 1000 or more but less than 5000, "C" if the number of particles was 5000 or more but less than 10000, and "D" if the number of particles was 10000 or more. The results are shown in Tables 1 to 4.

### "Thermal durability"

Thermal durability was evaluated. Specifically, cracking or delamination of the first resin layer after the thermal cycling process was evaluated. In other words, the electrostatic chuck was placed in a constant temperature chamber (TCC-151W manufactured by ESPEC Corporation) set to 0°C. Subsequently, the temperature was increased to 120°C at a heating rate of 50°C/hour, and then immediately decreased to 0°C at a cooling rate of 50°C/hour. This process was repeated 200 times. After 200 cycles, the electrostatic chuck was removed from the constant temperature chamber, and the appearance of each evaluation sample was observed and evaluated. Thermal durability was evaluated as follows: "A" if no cracks or peeling occurred in the first resin layer, "B" if only peeling occurred in the first resin layer, "C" if only cracks occurred **in** the first resin layer, and "D" if both peeling and cracking occurred in the first resin layer. The results are shown in Tables 1 to 4.

### "Evaluation of repairability"

Repairability was evaluated. Specifically, the peel strength of the first adhesive layer against the dielectric layer was measured at 23°C and 140°C **in** accordance with JIS-Z-0237. After cutting the first resin layer into strips 25 mm wide from the holding surface side of the electrostatic chuck 1, the electrostatic chuck was placed on a universal tensile testing machine (A&D Co., Ltd. RTH-2410), and the longitudinal end of the strip-shaped first resin layer was gripped with a test measurement jig provided on the universal tensile testing machine. Subsequently, the strip-shaped first resin layer was peeled from the dielectric layer under test temperatures of 23°C and 140°C, a peeling angle of 90°, and a test speed of 200 mm/min. The peeling strength was measured, and the presence or absence of residue on the dielectric layer was observed. Furthermore, this test was repeated three times, and the average peel strength was used as the peel strength to evaluate the repairability. Repairability was evaluated based on the presence or absence of adhesive residue. The results are shown in Table 5.

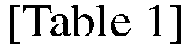

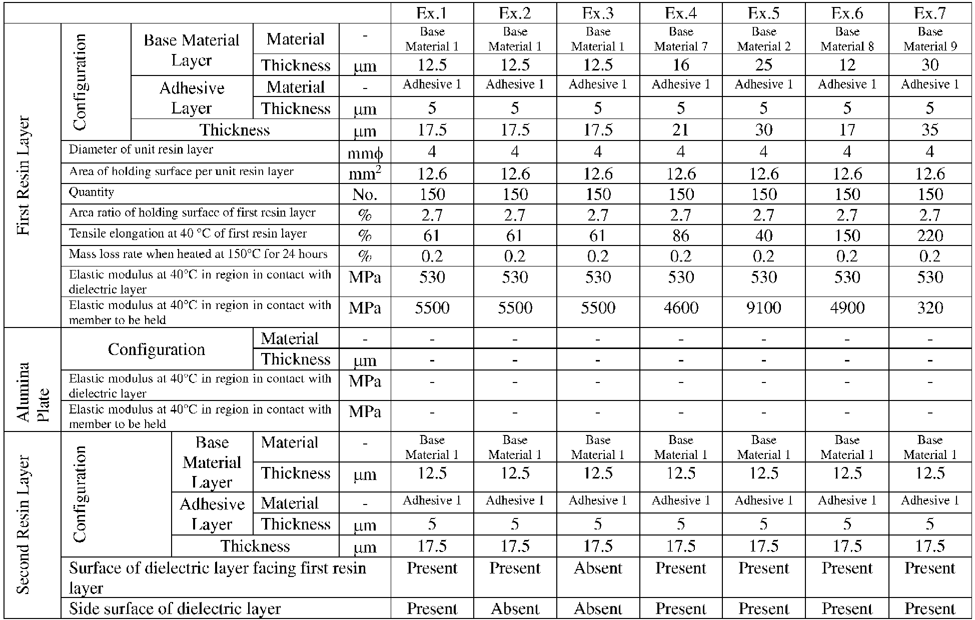

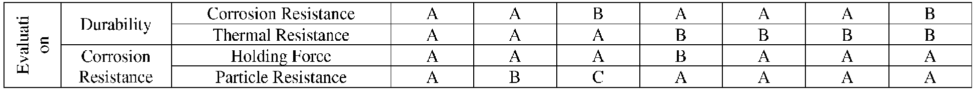

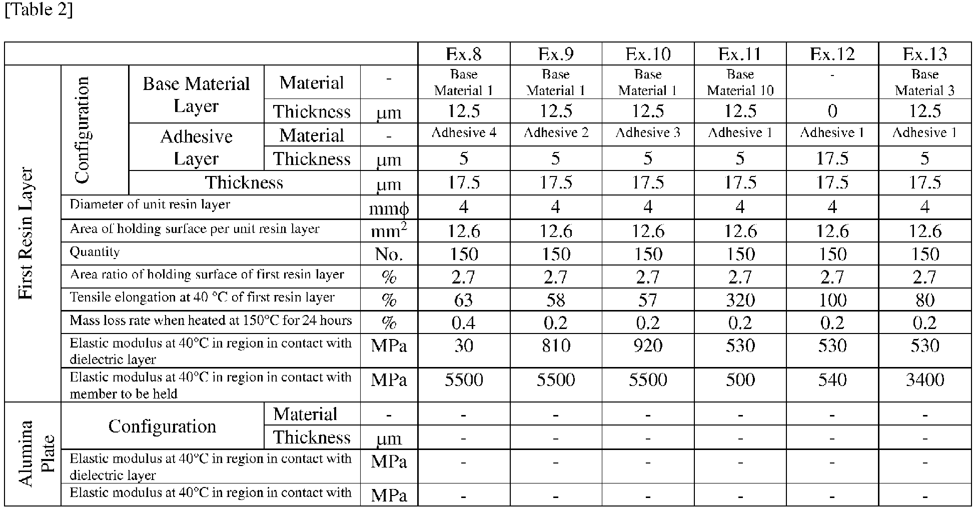

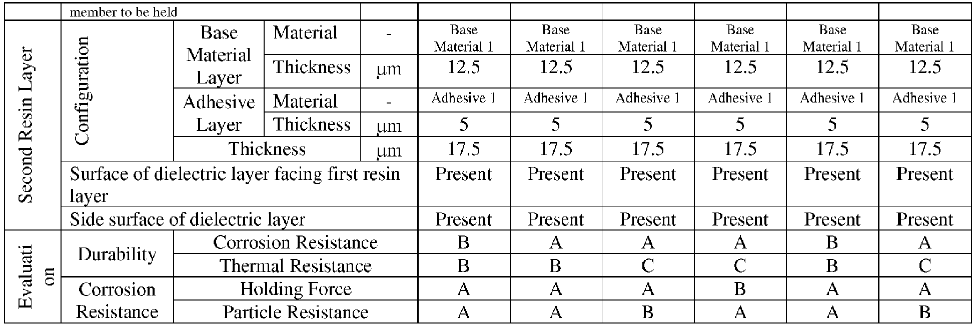

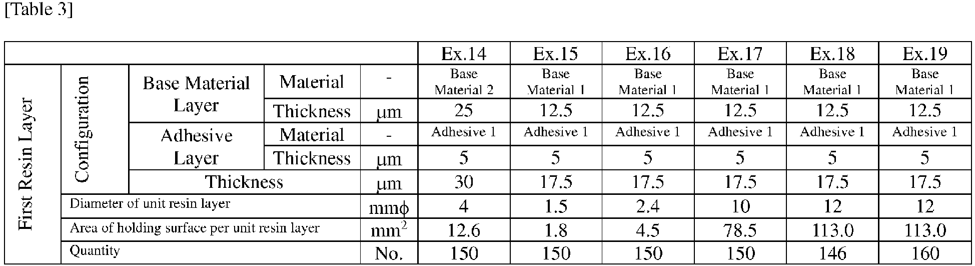

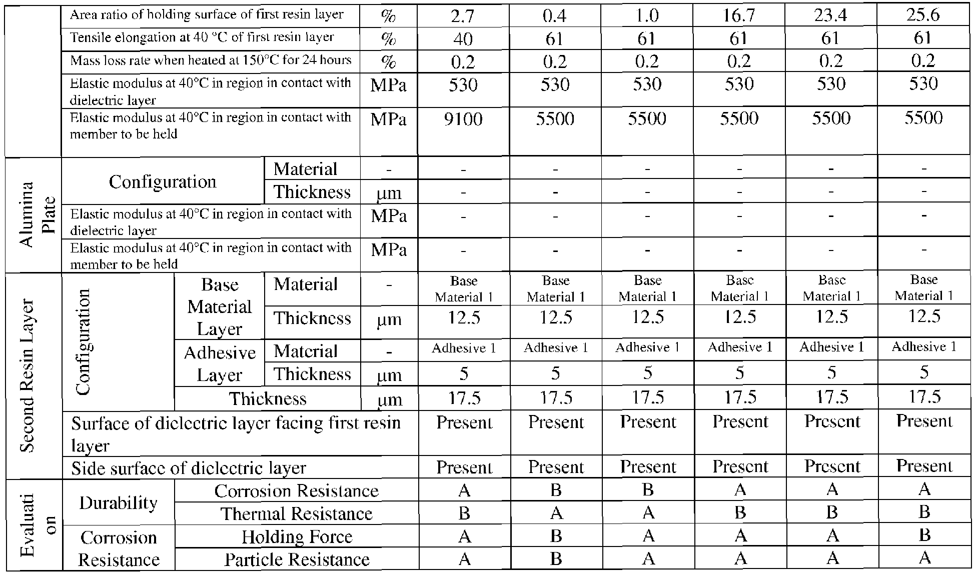

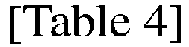

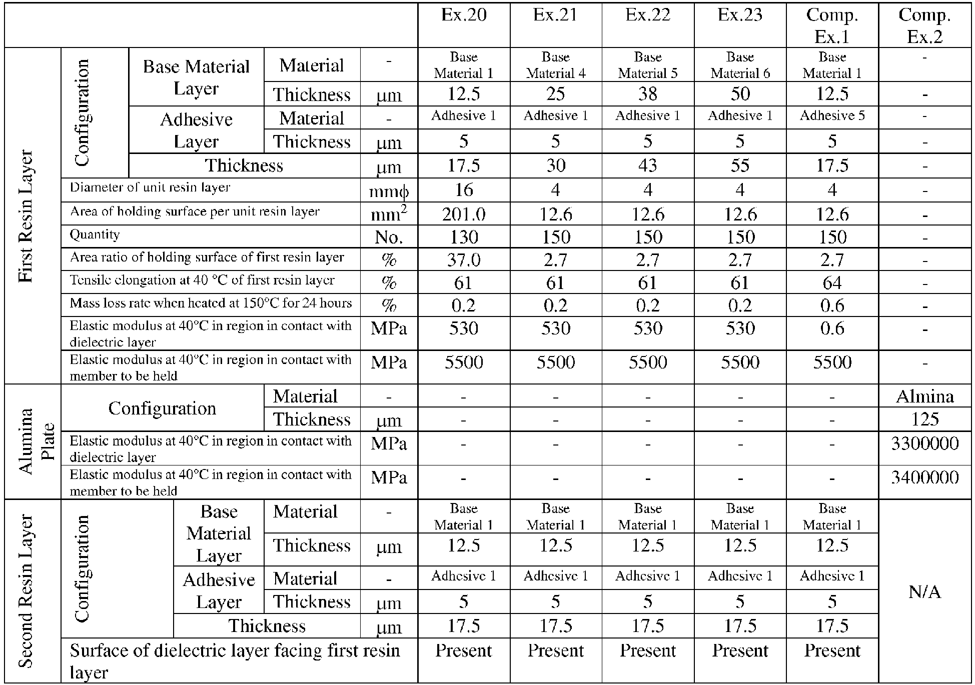

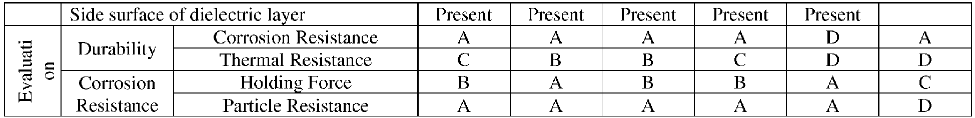

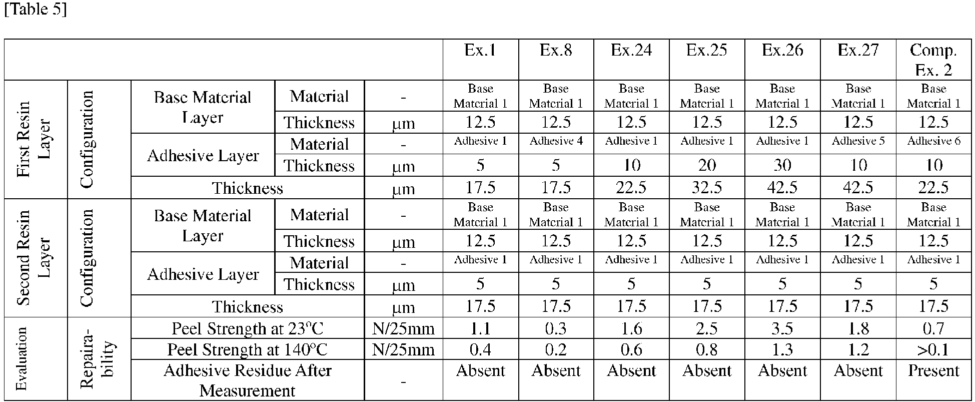

In Tables 1 to 4, base material 1 is Kapton 50EN manufactured by Toray DuPont, base material 2 is Kapton 50H manufactured by Toray DuPont, base material 3 is Upirex 25S manufactured by Ube Industries, Ltd., base material 4 is Kapton 100EN manufactured by Toray DuPont, base material 5 is Kapton 150EN manufactured by Toray DuPont, base material 6 is Kapton 200EN manufactured by Toray DuPont, base material 7 is Torelina #16-3030 manufactured by Toray, base material 8 is Lumirror #12-S10 manufactured by Toray, base material 9 is Torefan #30-2500H manufactured by Toray, and base material 10 is a tetrafluoroethylene-hexafluoropropylene copolymer film manufactured by Daikin Industries. Adhesive 1 is obtained by adding 5 parts by mass of JER604 manufactured by Mitsubishi Chemical Corporation to 100 parts by mass of PIAD100H manufactured by Arakawa Chemical Industries, Ltd. and mixing them. Adhesive 2 is obtained by adding 5 parts by mass of JER604 manufactured by Mitsubishi Chemical Corporation and 7 parts by mass of AA-04 manufactured by Sumitomo Chemical Corporation to 100 parts by mass of PIAD100H manufactured by Arakawa Chemical Industries, Ltd., and mixing them. Adhesive 3 is obtained by adding 5 parts by mass of JER604 manufactured by Mitsubishi Chemical Corporation and 10 parts by mass of AA-04 manufactured by Sumitomo Chemical Corporation to 100 parts by mass of PIAD100H manufactured by Arakawa Chemical Industries, Ltd., and mixing them together. Adhesive 4 was H1043, a styrene-ethylene-butylene-styrene block copolymer manufactured by Asahi Kasei Chemicals. Adhesive 5 is obtained by adding 3 parts by mass of hardener SC-55LT manufactured by Aica Kogyo Co., Ltd. to 100 parts by mass of Corponil 8976L manufactured by Mitsubishi Chemical Corporation and mixing them together. The above mixing ratio refers to the ratio in the adhesive composition after drying and solidification.

The results shown in Tables 1 to 4 indicate that the electrostatic chucks of Examples 1 to 23 exhibit excellent corrosion resistance and particle resistance.

The results shown in Table 5 indicate that the electrostatic chucks of Examples 1, 8, and 24-27 exhibit excellent repairability.

### REFERENCE SIGNS LIST

- 1, 100, 200: Electrostatic chuck
- 10: Dielectric layer
- 20: First resin layer
- 21: First adhesive layer
- 22: First base material layer
- 30: Internal electrode
- 40: Second resin layer
- 41: Second adhesive layer
- 42: Second base material layer

## Claims

1. An electrostatic chuck comprising:
a dielectric layer; and
a first resin layer provided on the dielectric layer,
wherein the first resin layer has a holding surface for holding a member to be held, and
the first resin layer has an elastic modulus of 10 MPa or more and 1000 MPa or less at 40°C in a region in contact with the dielectric layer.

2. The electrostatic chuck according to claim 1, wherein the first resin layer has a mass loss rate of 0.5% or less when heated at 150°C for 24 hours.

3. The electrostatic chuck according to claim 1, wherein the first resin layer has a tensile fracture elongation of 30% or more and 400% or less.

4. The electrostatic chuck according to claim 1, wherein the first resin layer has an elastic modulus of 100 MPa or more and 12,000 MPa or less at 40°C in the region in contact with the member to be held.

5. The electrostatic chuck according to claim 1, wherein, under a condition of 140°C, the peel strength of the first resin layer with respect to the dielectric layer is 0.1 N/25 mm or more and 2.0 N/25 mm or less.

6. The electrostatic chuck according to claim 1, wherein the first resin layer comprises a plurality of unit resin layers arranged spaced apart from each other.

7. The electrostatic chuck according to claim 1, wherein, in a plan view of the dielectric layer, the area of the holding surface is 50% or less of the area of the dielectric layer.

8. The electrostatic chuck according to claim 1, further comprising a second resin layer between the dielectric layer and the first resin layer.

9. The electrostatic chuck according to claim 8, wherein the second resin layer covers a surface of the dielectric layer facing the first resin layer and the side surface of the dielectric layer.
